# EUROPÄISCHE PATENTSCHRIFT

(11) **EP 0 472 897 B1**
(45) Veröffentlichungstag und Bekanntmachung des Hinweises auf die Patenterteilung: **14.12.1994**
(21) Anmeldenummer: 91112229.9
(22) Anmeldetag: 22.07.1991
(51) Int. Cl.: C23C 16/18, C07F 1/08

(54) **Verfahren zur Abscheidung einer Kupfer enthaltenden Schicht II**
Process for depositing copper containing layer II
Procédé pour déposer une couche contenant du cuivre II

(30) Priorität: 27.07.1990 DE 4023880
(43) Veröffentlichungstag der Anmeldung: 04.03.1992
(73) Patentinhaber: Kali-Chemie Aktiengesellschaft, D-30173 Hannover (DE)
(72) Erfinder: Kruck, Thomas, W-5024 Erftstadt-Bliesheim (DE); Terfloth, Christian, W-5000 Köln 41 (DE)
(74) Vertreter: Lauer, Dieter, Dr.

(56) Entgegenhaltungen:
- EP-A- 0 297 348
- US-A- 4 880 670
- JOURNAL OF THE AMERICAN CHEMICAL SOCIETY, Band 93, Nr. 22, 3. November 1971, USA, Seiten 5656-5661; T. SAEGUSA et al: "CYCLOPENTADIENYLCOPPER(I)-ISOCYANIDECOMPLEX."
- JOURNAL OF THE AMERICAN CHEMICAL SOCIETY, Band 96, Nr. 18, 4. September 1974, USA, Seiten 5930-5931; T. TSUDA et al: "T-BUOCU.CO AND T-BUOCU.CN-T-BU. NEW AND SUBLIMABLE COPPER-CARBONYL AND -ISOCYNIDE COMPLEXES"

## Beschreibung

Die Erfindung bezieht sich auf ein Verfahren zur Abscheidung einer Kupfer enthaltenden Schicht auf einem Substrat.

Es ist bekannt, Substrate durch Oberflächenbeschichtung so zu modifizieren, daß ihre Oberfläche bestimmte funktionale Eigenschaften aufweist. Beispielsweise kann man den elektrischen Strom leitende Schichten, z.B. Leiterbahnen auf Substraten aufbringen.

So offenbart die EP-A-0 297 348 ein Verfahren zur Herstellung Kupfer enthaltender Schichten. Dabei wird Triethylphosphin - Cyclopentadien - Kupfer thermisch oder photochemisch zersetzt.

Aufgabe der vorliegenden Erfindung ist es, ein Verfahren zur Abscheidung einer Kupfer enthaltenden Schicht auf einem Substrat anzugeben. Diese Aufgabe wird durch das erfindungsgemäße Verfahren gelöst.

Das erfindungsgemäße verfahren zur Abscheidung einer Kupfer enthaltenden Schicht auf einem Substrat ist dadurch gekennzeichnet, daß man durch Zersetzung einer Verbindung der allgemeinen Formel R-Cu-L (I), worin R für einen organischen Rest R¹ oder R² steht und
R¹Cyclopentadien und R²substituiertes Cyclopentadien der allgemeinen Formel C₅X¹X²X³X⁴X⁵ bedeutet, worin X¹, X², X³, X⁴ und X⁵ gleich oder verschieden sein können und Wasserstoff; lineares oder verzweigtes Alkyl mit 1 bis 5 C-Atomen; durch Halogen oder durch Organylsilyl, insbesondere Trimethyl- oder Triethylsilyl substituiertes lineares oder verzweigtes Alkyl mit 1 bis 5 C-Atomen; Halogen, insbesondere Chlor; Aryl, insbesondere Phenyl, substituiertes Phenyl, insbesondere Tolyl; Organylsilyl, insbesondere Trimethyl- oder Triethylsilyl, -COOR³, worin R³ für Niedrigalkyl mit 1 bis 3 C-Atomen steht, bedeuten und
L für (C1-C6-Alkyl)isonitril oder Arylisonitril, insbesondere Phenylisonitril oder Tolylisonitril, steht,
eine Kupfer enthaltende Schicht auf dem Substrat aufbringt.

Bevorzugt verwendet man Verbindungen, in welchen R für R¹ steht, oder in welchen R für R² steht und X¹, X² X³, X⁴ und X⁵ gleich oder verschieden sein können und Wasserstoff; Methyl, Ethyl, Isopropyl, Trifluormethyl, Phenyl, Chlor oder -COO(Methyl) bedeuten. Selbstverständlich ist in Verbindungen mit R² mindestens einer der Substituenten X¹ bis X⁵ nicht Wasserstoff.

Bevorzugt steht L für (C1-C6-Alkyl)isonitril. Besonders bevorzugt steht L für ein Alkylisonitril, dessen Alkylgruppe verzweigt ist und 3 bis 5 C-Atome aufweist. Insbesondere bevorzugt steht L für t-Butylisonitril.

Ganz besonders bevorzugt verwendet man Verbindungen, in welchen R Cyclopentadien; Methylcyclopentadien, Ethylcyclopentadien, Isopropylcyclopentadien; Pentamethylcyclopentadien; Trifluormethylcyclopentadien; Tetraphenylcyclopentadien; Methoxycarbonylcyclopentadien; Pentakis-(Methoxycarbonyl)cyclopentadien bedeutet.

Zur Abscheidung einer Kupfer enthaltenden Schicht kann der Fachmann die Abscheidung aus der kondensierten Phase oder aus der Gas- bzw. Dampfphase vornehmen. Für den Fachmann ist dabei selbstverständlich, daß er nicht nur eine bestimmte Verbindung der allgemeinen Formel (I), sondern auch Gemische solcher Verbindungen einsetzen kann.

Zur Abscheidung aus der kondensierten Phase bringt der Fachmann die Verbindung der Formel (I) ohne Lösungsmittel oder vorzugsweise in einem Lösungsmittel gelöst auf dem Substrat auf und zersetzt die Verbindung. Als Lösungsmittel können polare oder unpolare, aprotische organische Lösungsmittel, die gewünschtenfalls koordinierende Eigenschaften aufweisen können, verwendet werden. Geeignet sind beispielsweise aliphatische Kohlenwasserstoffe wie Pentan oder Petrolbenzin, aromatische Kohlenwasserstoffe wie Benzol oder Toluol oder Ether wie Tetrahydrofuran.

Um die jeweilige Ausgangsverbindung auf dem Substrat aufzubringen, kann man sich bekannter Methoden bedienen, beispielsweise kann man das Substrat in die Verbindung oder eine entsprechende Lösung eintauchen, man kann die Ausgangsverbindung oder eine entsprechende Lösung auf dem Substrat aufstreichen oder, bevorzugt, die Verbindung oder eine entsprechende Lösung auf das Substrat aufsprühen.

Mittels dieser Ausführungsform des erfindungsgemäßen Verfahrens, nämlich dem Aufbringen der Ausgangsverbindung (bzw. einem entsprechenden Gemisch von Ausgangsverbindungen) aus der kondensierten Phase, gelingt es, auch große Flächen sehr schnell zu beschichten.

Dann erfolgt die Zersetzung der auf dem Substrat aufgebrachten Ausgangsverbindung zur Abscheidung einer Kupfer enthaltenden Schicht, gewünschtenfalls unter vermindertem Druck. Bevorzugt bewirkt man die Zersetzung thermisch.

Dies kann durch Einbringen des mit der Ausgangsverbindung beschichteten Substrats in eine entsprechend beheizte Kammer, durch Heizen des Substrats vor, während und/oder nach dem Aufbringen der Ausgangsverbindung auf den angegebenen Temperaturbereich erfolgen.

Die thermische Zersetzung kann auch strahlungsinduziert bewirkt werden, beispielsweise durch einen Laser, der im UV-Bereich, im Infrarot-Bereich oder im Bereich des sichtbaren Lichts arbeitet und den Träger aufheizt.

Gewünschtenfalls kann die Zersetzung auch durch Photolyse erfolgen. Die photolytische Zersetzung kann durch einen bei der entsprechenden Wellenlänge betriebenen Laser oder einer UV-Lampe bewirkt werden.

Die Zersetzung kann man auch plasmainduziert durchführen. Hierzu eignen sich die verschiedenen bekannten Verfahren.

Beispielsweise kann man ein thermisches Plasmaverfahren, z.B. Lichtbogenplasma oder Pasmajet, anwenden. Der Druck liegt dann üblicherweise zwischen 10 Torr und Normaldruck.
Gut geeignet sind insbesondere auch Niederdruckplasmaverfahren, z.b. Gleichstromplasmaverfahren, Glimmentladungsplasmaverfahren und Wechselstromplasmaverfahren, z.B. Niederfrequenz-, Mittelfrequenz-, Hochfrequenzplasmaverfahren und Mikrowellenplasmaverfahren. Man arbeitet üblicherweise bei Drucken unterhalb 10 mbar, beispielsweise zwischen 10⁻² und 1 mbar.

Die plasmainduzierte Zersetzung in einem Glimmentladungsplasma erfolgt in bekannten Plasmareaktoren. Verwendbar sind beispielsweise Rohr-, Tunnel-, Parallelplatten- und und Coronaentladungsreaktoren. Da die Zersetzung im Plasma gewünschtenfalls bei niedrigen Temperaturen durchgeführt werden kann, ist die Zersetzung im Plasma gut geeignet zur Beschichtung von Substraten mit verhältnismäßig geringerer Thermostabilität, beispielsweise für Beschichtung von Kunststoffen.

Der Fachmann kann durch Zusatz eines Reaktivgases die Form, in welcher das Kupfer in der Schicht vorliegt, beeinflussen. Dies, sowie die Möglichkeit der gleichzeitigen Abscheidung anderer Metalle oder der sukzessiven Abscheidung weiterer, insbesondere weiterer Schichten mit anderer Zusammensetzung, wird noch erläutert.

Eine andere Ausführungsform des erfindungsgemäßen Verfahrens betrifft die Zersetzung der Ausgangsverbindung in der Gas- bzw. Dampfphase. In der Dampfphase sind neben der gasförmigen vorliegenden Ausgangsverbindung auch noch Anteile der kondensiert vorliegenden Ausgangsverbindung in feinster Verteilung enthalten. Die Abscheidung aus der Gas- bzw. Dampfphase ermöglicht die Abscheidung besonders gut haftender, gleichmäßiger, dünner Schichten.

Der Druck in der Dampfphase bzw. Gasphase kann mehr oder weniger hoch sein. Man kann beispielsweise bei einem Druck arbeiten, der dem Dampfdruck der verwendeten Ausgangsverbindung bei der Arbeitstemperatur entspricht. Der Gesamtdruck kann aber auch höher sein, bis hin zum Normaldruck. Zweckmäßig arbeitet man bei vermindertem Druck, beispielsweise bei 10⁻² bis 10 mbar, vorzugsweise bei 0,1 bis 1 mbar.

Die Zersetzung der Ausgangsverbindung in der Dampfphase oder Gasphase führt man zweckmäßig nach Art eines CVD(Chemical-Vapour-Deposition)-Verfahrens durch.

Die prinzipielle Vorgehensweise zur Beschichtung von Substraten unter Anwendung von CVD-Verfahren sowie geeigneter Apparaturen dafür sind bekannt. Die EP-A 297 348 (die sich mit ähnlichen Beschichtungen befaßt wie die vorliegende Erfindung) gibt dem Fachmann ausführliche Hinweise, wie ein CVD-Verfahren durchzuführen ist und welche Apparaturen verwendbar sind.

Die Zersetzung aus der Gas- bzw. Dampfphase wird zweckmäßig in einer druckfesten, evakuierbaren Vorrichtung durchgeführt. In diese Vorrichtung wird das zu beschichtende Substrat eingebracht. Bei vermindertem Druck wird eine Atmosphäre erzeugt, welche die Kupfer enthaltende Ausgangsverbindung enthält. Neben der gas-bzw. dampfförmigen Ausgangsverbindung kann gewünschtenfalls Inertgas oder Reaktivgas im Gasraum der Vorrichtung vorhanden sein.

In einer Variante wird die Ausgangsverbindung zusammen mit dem zu beschichtenden Substrat in die Vorrichtung eingebracht.

In einer alternativen, bevorzugten Variante wird zunächst nur das Substrat in die druckfeste Vorrichtung eingebracht und die bereits gas- bzw. dampfförmig vorliegende Ausgangsverbindung über eine besondere Leitung kontinuierlich oder diskontinuierlich in die Vorrichtung eingebracht. Auch hier kann ein Trägergas angewendet werden.

Die Überführung der Ausgangsverbindung in die Gas- bzw. Dampfphase kann man durch Erwärmen und gewünschtenfalls durch Zusatz eines Trägergases unterstützen.

Die Zersetzung erfolgt nach bekannten Methoden thermisch, durch Einwirkung eines Plasmas und/oder photolytisch.

Die thermische Zersetzung aus der Gas- bzw. Dampfphase führt man üblicherweise so durch, daß die Wände der Vorrichtung kalt gehalten werden und das Substrat auf eine Temperatur erhitzt wird, bei welcher sich die gewünschte Kupfer enthaltende Schicht auf dem Substrat abscheidet. Der Fachmann kann durch einfache orientierende Versuche für die jeweils eingesetzte Verbindung die notwendige Mindesttemperatur leicht bestimmen. Üblicherweise liegt die Temperatur, auf welche das Substrat erhitzt wird, oberhalb von 80 °C.

Die Beheizung der Substrate kann in üblicher Weise erfolgen, beispielsweise durch Widerstandsheizung, Induktionsheizung, elektrische Heizeinrichtung wie Heizwendeln oder ähnlichem. Die Aufheizung der Substrate kann auch durch Strahlungsenergie induziert werden. Hierfür eignet sich insbesondere Laserstrahlungsenergie. Beispielsweise kann man Laser verwenden, die im Bereich des sichtbaren Lichtes, im UV-Bereich oder im IR-Bereich arbeiten. Laser besitzen den Vorteil, daß man sie mehr oder weniger fokussieren kann und daher gezielt bestimmte, begrenzte Bereiche oder Punkte des Substrats erhitzen kann.

Da das thermische CVD-Verfahren üblicherweise bei Unterdruck durchgeführt wird, ist es für den Fachmann selbstverständlich, druckfeste Apparaturen vorzusehen, wie sie in der Vakuumtechnik verwendet werden. Die Apparaturen weisen zweckmäßigerweise beheizbare Gasleitungen für die metallorganische Verbindung oder das Inertgas, absperrbare Öffnungen für Gasein- und Auslaß auf, gegebenenfalls Öffnungen zur Zuführung eines Träger- oder Reaktivgases, Temperaturmeßeinrichtungen, gewünschtenfalls eine Öffnung für die Zuführung der metallorganischen Verbindung, eine Einrichtung für die Aufheizung des Substrats muß vorhanden sein, eine zur Erzeugung des gewünschten Unterdruckes geeignete Pumpe etc. Für den Fall der Durchführung eines durch Strahlungsenergie induzierten CVD-Verfahrens muß auch noch eine Strahlungsquelle vorhanden sein, die Strahlung im Bereich des sichtbaren Lichtes, des Infrarot- oder Ultraviolett-Bereiches abgibt. Besonders geeignet sind entsprechende Laser-Strahlungsenergiequellen. Mittels der Strahlungsenergie kann das Substrat aufgeheizt werden.

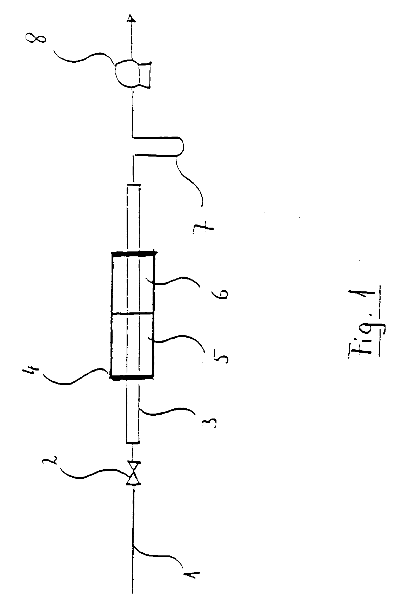

Eine sehr einfache, zweckmäßige Vorrichtung zur Verfahrensdurchführung ist in Fig. 1 wiedergegeben.

Sie umfaßt ein mit einer Inertgaszuleitung 1 über ein absperrbares Ventil 2 verbundenes Glasrohr 3, das konzentrisch in einem röhrenförmig aufgebauten Heizofen 4 angeordnet ist, welcher zwei Heizzonen 5 und 6 aufweist ("Zweizonenröhrenofen"). Die andere Seite des Rohres ist über eine Kühlfalle 7 mit einer Vakuumpumpe 8 verbunden.

In die erste Heizzone, die auf der Seite der Inertgaszuleitung liegt, wird die Ausgangsverbindung eingebracht. In die zweite Heizzone, die auf der Seite der Vakuumpumpe liegt, bringt man das Substrat ein.

Die plasmainduzierte Zersetzung führt man in einer schon vorstehend beschriebenen Apparatur durch.

Ohne daß hier eine Erklärung für die Bildung von Schichten durch Zersetzung der Kupferverbindungen gegeben werden soll, wird angenommen, daß Gase bzw. Dämpfe der Kupferverbindung auf das Substrat gelangen und dort unter Bildung der Kupfer enthaltenden Schichten zersetzt werden. Die Dicke der Schichten ist im wesentlichen abhängig vom Partialdruck, von der Zeitdauer, während welcher die Abscheidung durchgeführt wird, und von der Abscheidungstemperatur. Es lassen sich mehr oder weniger dünne Schichten erzeugen, beispielsweise Schichten mit einer Dicke von bis zu 20 Mikrometer, beispielsweise zwischen 100 Angström und 20 Mikrometer. Je nach gewünschter Schichtdicke kann der Fachmann durch orientierende Versuche die zur Erzeugung einer Kupfer enthaltenden Schicht bestimmter Dicke notwendige Zeitdauer und Abscheidungstemperatur bestimmen.

Wie schon gesagt, kann die Zersetzung auch photolytisch bewirkt werden, z.B. durch eine UV-Lampe oder durch einen mit geeigneter Wellenlänge arbeitenden Laser.

Die Anwendung eines Lasers ermöglicht beispielsweise die Reparatur von Leiterbahnen.

Der das Substrat umgebende Gasraum enthält die gas- bzw. dampfförmig vorliegende Ausgangsverbindung. Es wurde bereits weiter oben erwähnt, daß weiterhin ein Inertgas oder ein Reaktivgas in der Gasatmosphäre enthalten sein kann. Abhängig von der Art der Durchführung werden ganz unterschiedliche Kupfer enthaltende Schichten abgeschieden.

Zersetzt man die Ausgangsverbindung ohne Zusatz eines Inertgases oder eines Reaktivgases, so scheiden sich bei der Zersetzung, insbesondere bei der Durchführung als CVD-Verfahren, Schichten ab, die Kupfer im wesentlichen in metallischer Form enthalten.

Schichten, die bei thermischer Zersetzung insbesondere in einem thermischen CVD-Verfahren Kupfer im wesentlichen in metallischer Form enthalten, werden auch abgeschieden, wenn man in Anwesenheit eines Inertgases, beispielsweise in Anwesenheit von Edelgasen wie Argon arbeitet.

In einer anderen Ausführungsform führt man die Zersetzung in einer Reaktivgasatmosphäre durch. Eine solche reaktive Gasatmosphäre kann natürlich zusätzlich Inertgas enthalten, beispielsweise Edelgase wie Argon.

In einer Variante arbeitet man in einer reduzierenden Reaktivgasatmosphäre. Man führt die Zersetzung insbesondere nach Art eines thermischen oder plasmainduzierten CVD-Verfahrens durch. Die Zersetzung der Kupfer enthaltenden Ausgangsverbindung in einer reduzierenden Reaktivgasatmosphäre, welche insbesondere Wasserstoff enthält, ergibt Kupfer enthaltende Schichten, welche das Kupfer im wesentlichen in metallischer Form enthalten.

Eine Variante des erfindungsgemäßen Verfahrens ist dadurch gekennzeichnet, daß man zur Abscheidung von Kupfer enthaltenden Schichten, welche das Kupfer im wesentlichen in Form von Kupferoxid enthalten, die Zersetzung in Gegenwart einer reaktiven, hydrolysierenden und/oder oxidierenden Gasatmosphäre durchführt.

Zur Abscheidung von Kupfer enthaltenden Schichten, welche das Kupfer im wesentlichen in Form von Kupfer (I)-oxid enthalten, führt man die Zersetzung in Gegenwart insbesondere von Wasserdampf durch. Zur Abscheidung von Kupfer enthaltenden Schichten, welche das Kupfer im wesentlichen in Form von Kupfer(II)oxid enthalten, führt man die Zersetzung in Gegenwart einer oxidierenden Gasatmosphäre, insbesondere in Gegenwart von Sauerstoff, Ozon oder Distickstoffoxid durch.

Im erfindungsgemäßen Verfahren kann man im Prinzip beliebige Substrate beschichten, auf denen eine Beschichtung wünschenswert ist. Beispielsweise kann man anorganische Materialien, wie Metalle, Halbleiter, Isolatoren, Keramik, Glasphasen, oder organische Polymere, z.B. Polyphenylensulfid oder Polyimide, als Substrate verwenden.

Weiterhin kann man Substrate verwenden, die auch bei der Supraleiterherstellung verwendet werden, wie Kohlenstoff, insbesondere Kohlenstoffasern, oder beispielsweise Strontiumtitanat, Aluminiumoxid oder Magnesiumoxid.

Die Abscheidung von Schichten, die das Kupfer im wesentlichen in Form von metallischem Kupfer enthalten, ermöglicht beispielsweise unter Abdeckung bestimmter nicht zu beschichtender Bereiche nach an sich bekannten Strukturierungsverfahren die Erzeugung für den elektrischen Strom leitfähiger Leiterbahnen auf nichtleitenden Substraten, beispielsweise auf Keramik oder organischen Polymeren.

Das erfindungsgemäße Verfahren bietet dem Fachmann aber noch weitere Möglichkeiten. Es eignet sich beispielsweise auch zur Abscheidung von Schichten, welche neben dem Kupfer ein oder mehrere andere Metalle enthalten. Diese Ausführungsform des erfindungsgemäßen Verfahrens ist dadurch gekennzeichnet, daß man zur Abscheidung von Kupfer enthaltenden Schichten, welche weiterhin ein oder mehrere andere Metalle enthalten, eine oder mehrere Verbindungen anderer Metalle, insbesondere Verbindungen des Aluminiums, und eine Verbindung der allgemeinen Formel (I) gleichzeitig zersetzt. Es bilden sich dann Schichten, die Kupfer und ein oder mehrere andere Metalle in homogener Mischung enthalten und beständiger gegen Elektromigration sind. Die gleichzeitige Verdampfung und Zersetzung von Kupferverbindungen der allgemeinen Formel (I) und Aluminiumverbindungen, beispielsweise Di-i-butylaluminiumhydrid, oder Tri-i-butylaluminium eignet sich beispielsweise zur Herstellung elektromigrationsbeständiger Leiterbahnen. Auch bei dieser Ausführungsform kann man in inerter oder Reaktivgasatmosphäre arbeiten.

Weiterhin kann der Fachmann mehrere unterschiedliche Schichten sukzessive nacheinander auf Substraten aufbringen, wobei mindestens eine Schicht gemäß dem erfindungsgemäßen Verfahren erzeugt wird.

Weiterhin kann man durch gleichzeitige Verdampfung und Zersetzung von Kupferverbindungen der allgemeinen Formel (I) und entsprechenden anderen verdampfbaren Verbindungen in reaktiver, hydrolysierender und/oder oxidierender Atmosphäre Schichten abscheiden, die in ihrer Zusammensetzung bekannten oxidkeramischen Hochtemperatur supraleitern des Kuprat-Typs entsprechen. Man verwendet z.B. β-Diketonate von Yttrium, Barium, Strontium und anderen Metallen. Geeignet sind z.B. die entsprechenden Tetramethylheptandionate.

Weiterhin ist es möglich, zwei oder mehr unterschiedliche Schichten nacheinander abzuscheiden, wobei mindestens eine der Schichten nach dem erfindungsgemäßen Verfahren erzeugt worden ist.

Beispielsweise kann man zunächst eine die Haftung vermittelnde Titannitrid-Schicht nach bekannten Methoden, z.B. PVD- oder CVD-Verfahren, auf Substraten aufbringen. Anschließend zersetzt man eine Verbindung der allgemeinen Formel (I) zur Bildung von Leiterbahnen.

Ganz besonders eignet sich diese Ausführungsform des erfindungsgemäßen Verfahrens zur Beschichtung von Substraten mit oxidkeramischen Schichten, die in ihrer Zusammensetzung bekannten Hochtemperatursupraleitern des Kuprat-Typs entsprechen.

Substrate, die mit solchen Hochtemperatursupraleitern beschichtet werden, sind bekannt. Diese Substrate können beispielsweise in Form von Fasern, Bändern, Folien, Rohren, oder in Form von Platten ausgebildet sein.Man verwendet beispielsweise Kohlenstoffasern. Auf einen solchen Träger bringt man, wie vorstehend schon beschrieben, nach dem erfindungsgemäßen Verfahren unter Verwendung einer Verbindung der allgemeinen Formel (I) eine Schicht auf, die das Kupfer in Form von Kupferoxid enthält.

Die Abscheidung von Schichten, die die übrigen in bekannten oxidischen Supraleitern enthaltenen Metalle aufweisen, beispielsweise Yttrium und Barium zur Herstellung einer Zusammensetzung Y₁Ba₂Cu₃Oₓ, worin x einen Wert zwischen 6,8 und 6,95 aufweist, werden in bekannter Weise erzeugt. Beispielsweise kann man Komplexverbindungen von Yttrium und Barium mit β-Diketonen, insbesondere 2,2,6,6-Tetramethylheptandion(3,5) verwenden. Man verdampft also beispielsweise Yttrium-tris-2,6,6,6-tetramethylheptandionat(3,5) bei Temperaturen zwischen Raumtemperatur und 500 °C und zersetzt diese Verbindung bei 500 °C bis 700 °C. Auf die nach dem erfindungsgemäßen Verfahren erzeugte Kupferoxid enthaltende Schicht wird dann eine Yttriumoxid enthaltende Schicht abgeschieden. Anschließend wird beispielsweise Barium-bis-2,2,6,6-tetramethylheptandionat(3,5) unter den gleichen Bedingungen verdampft und zersetzt. Die Reihenfolge kann verändert werden.

Zur Überführung in einen Yttrium-Barium-Kuprat-Hochtemperatursupraleiter wird die Beschichtung dann noch getempert.

In völlig analoger Weise können modifizierte oxidkeramische Schichten hergestellt werden, indem man einen Teil des Yttriums durch Strontium, Lanthan, Thallium, Wismut oder andere Metalle ersetzt, die zweckmäßig ebenfalls in Form der Metall-β-Diketonate, beispielsweise als Metall-2,2,6,6-Tetramethylheptandionat(3,5) eingesetzt werden.

Die Dicke der abgeschiedenen supraleitenden Schicht beträgt zweckmäßig von etwa 5 bis 20 Mikrometer.

Im folgenden wird die Herstellung der Verbindungen der allgemeinen Formel (I) beschrieben.

Die Herstellung von Verbindungen der allgemeinen Formel (I) kann in einer mehrstufigen Synthese erfolgen. In dieser mehrstufigen Synthese kann man ausgehen von der Verbindung t-BuO-Cu. Dieses Zwischenprodukt wird aus wasserfreiem CuCl und t-BuO-Li in Tetrahydrofuran unter Stickstoffatmosphäre bei Umgebungstemperatur als hellgelber Feststoff erhalten, siehe auch T. Tsuda, T. Hashimoto und T. Saegusa in J. Am. Chem. Soc. 94 (1972), Seiten 658 und 659. Das hierbei erhaltene t-BuO-Cu wird dann mit Alkyl- oder Arylisonitril (als Handelsprodukte erhältlich) versetzt. Die Herstellung wird anhand der ganz besonders bevorzugten Verwendung von t-Butylisonitril weiter erläutert. Die Kupferverbindung wird also mit t-BuNC (als Handelsprodukt erhältlich) versetzt, wobei sich t-BuO-Cu-t-BuNC bildet, welches dann mittels Cyclopentadien in C₅H₅-Cu-t-BuNC überführt wird, siehe auch T. Tsuda, H.H.S. Horiguchi und T. Saegusa in J. Am. Chem. Soc. 96 (1974), Seiten 5930 und 5931.

Die Herstellung anderer Verbindungen der allgemeinen Formel (I), in welchen R für R² steht, wobei R² die oben genannte Bedeutung besitzt, erfolgt in analoger Weise durch Zugabe des dem Rest R² entsprechenden substituierten Cyclopentadiens zu t-BuO-Cu-t-BuNC unter Bildung der jeweiligen subst.-Cyclopentadien-Cu-t-BuNC-Verbindung. Die hierfür benötigten substituierten Cyclopentadien-Verbindungen sind bekannt und zum Teil Handelsprodukte.

Ein anderes Verfahren zur Herstellung von Verbindungen der allgemeinen Formel (I) kann einstufig durchgeführt werden und ist deshalb besonders einfach. T. Saegusa, Y. Ito und S. Tomita beschreiben in J. Am. Chem. Soc. 93 (1971), Seiten 5656 bis 5661 die Herstellung von C₅H₅-Cu-t-BuNC aus Cu₂O, t-BuNC und Cyclopentadien bei 50 °C unter Stickstoffatmosphäre. Die Reaktanden werden 50 Minuten lang bei der Temperatur gerührt und die Reaktionsmischung nach Zusatz von Ether filtriert. Zum Filtrat wurde n-Pentan zugegeben. C₅H₅-Cu-t-BuNC fällt aus der Lösung aus und kann durch Filtrieren isoliert werden.

In analoger Weise können unter Anwendung von dem Rest R² entsprechenden substituierten Cyclopentadien-Verbindungen bzw. anderen Isonitrilen die anderen Verbindungen der allgemeinen Formel (I) hergestellt werden.

Das erfindungsgemäße Verfahren weist Vorteile gegenüber bekannten Verfahren auf. Die Zersetzung erfolgt bereits ab etwa 80 °C und kann daher substratschonend durchgeführt werden.

Die Ausgangsverbindungen weisen weiterhin einen vorteilhafterweise verhältnismäßig geringen Kohlenstoffgehalt auf. Die Zersetzung durch Photolyse, z.B. durch Anwendung eines Lasers, ist zudem einfacher, da die Isonitrilgruppe photolytisch angeregt werden kann.

Die folgenden Beispiele sollen die Erfindung weiter erläutern, ohne sie in ihrem Umfang einzuschränken.

### Beispiel 1:

### Herstellung von C₅H₅-Cu-t-BuNC

Bei der Herstellung wurden getrocknete, unter Stickstoff-Atmosphäre destillierte Lösungsmittel eingesetzt. Sämtliche Verfahrensstufen wurden unter Inertgas-Atmosphäre durchgeführt.
5.0 g (35 mmol) Cu₂O, 5.0 g (60 mmol) t-BuNC und 16,5 g (250 mmol) frisch destilliertes Cyclopentadien wurden vermischt und auf 50 °C, aber nicht höher, unter Rühren erwärmt. Nach ca. 20 Minuten färbte sich das Reaktionsgemisch orange und nahm eine schleimige Konsistenz an. Es wurde noch 30 Minuten bei 50 °C weitergerührt. Anschließend ließ man das Reaktionsgemisch abkühlen und fügte 50 ml Diethylether zu. Überschüssiges Cu₂O wurde abfiltriert und das erhaltene, dunkle Filtrat mit 30 ml n-Pentan versetzt. Bereits bei Umgebungstemperatur setzte eine Kristallisation des Produktes ein. Zur Vervollständigung der Kristallisation wurde das Filtrat eisgekühlt.
Nach 12 Stunden wurde dann die Mutterlauge abgetrennt und die verbleibenden Kristalle zweimal mit je 10 ml n-Pentan gewaschen. Das farblose Produkt wurde anschließend 2 Stunden lang bei Raumtemperatur und 10-3 mbar getrocknet. Ausbeute: 6,9 g/55 % der Theorie, bezogen auf eingesetztes t-Butylisonitril. Gewünschtenfalls kann das Produkt durch Umkristallisation oder Sublimation gereinigt werden.
Zersetzungspunkt: 95 °C
Sublimationspunkt: 45 °C/10⁻³ mbar

### Beispiel 2:

Anwendung von C₅H₅-Cu-t-BuNC zur Abscheidung von Kupfer enthaltenden Schichten.

### 2.1. Verwendete Apparatur

Verwendet wurde eine entsprechend Fig. 1 aufgebaute Vorrichtung.
Ein Quarzglasrohr war konzentrisch in einen 2-Zonenröhrenofen eingebracht. Die eine Seite des Quarzrohres war absperrbar mit einer Inertgasleitung verbunden, die andere Seite mit einer Vakuumpumpe. Zwischen Quarzrohr und Vakuumpumpe befand sich eine tiefkühlbare Falle zur Abtrennung flüchtiger Bestandteile aus dem abgepumpten Gasstrom.
Die zu verdampfende metallorganische Verbindung wurde in einem Porzellanschiffchen in das Glasrohr in der 1. Heizzone des 2-Zonenröhrenofens positioniert. Das Substrat wurde in die 2. Heizzone eingebracht. In einem Anwendungsbeispiel diente die Glasrohrwand in der 2. Heizzone gleichzeitig als Substrat.

### 2.2. Versuchsdurchführung

### 2.2.1. Anwendung von Glas als Substrat

Als Substrat fungierte die Quarzglasrohrwand. Als Ausgangsverbindung wurde das gemäß Beispiel 1 hergestellte C₅H₅-Cu-t-BuNC eingesetzt.
Die Heizzone 2 wurde auf etwa 200 °C gebracht. Der Druck betrug etwa 1 mbar. Die in die Heizzone 1 des Quarzrohres eingebrachte Ausgangsverbindung wurde auf 50 °C erwärmt. Die Ausgangsverbindung trat in die Gasatmosphäre über und wurde, unter Einleiten eines Stickstoffstroms (etwa 25 ml/min) in das Quarzrohr, durch das Quarzrohr geleitet.
Nach etwa 30 Minuten wurde die Abscheidung beendet und über die Inertgasleitung das Glasrohr mit gereinigtem Stickstoff auf Normaldruck gebracht. Auf dem Glasrohr in der Heizzone 2 hatte sich eine Kupferschicht abgeschieden.

### 2.2.2. Anwendung von Polyphenylensulfid als Substrat

Die Versuchsdurchführung erfolgte wie in 2.2.1. beschrieben. Als Substrat wurde eine entfettete Probe Polyphenylensulfid (Tedur^{R} der Firma Bayer Leverkusen) auf der Glasrohrwand in Heizzone 2 angebracht. Die Temperatur in Heizzone 1 betrug 50 °C, 200 °C in Heizzone 2, und die Abscheidedauer betrug 30 Minuten. Das Polyphenylensulfid wurde dann aus der Heizzone 2 entnommen. Auf der Probe hatte sich eine Kupferschicht abgeschieden.

### 2.2.3. Anwendung von Polyimid als Substrat

Die Verfahrensdurchführung erfolgte wie in 2.2.1. beschrieben. Als Substrat wurde Polyimid (Capton^{R} der Firma Dupont) in entfettetem Zustand auf der Glasrohrwand in Heizzone 2 angebracht. Die Temperatur in Heizzone 1 betrug 50 °C, in Heizzone 2 betrug sie 200 °C, und die Abscheidedauer betrug 30 Minuten. Danach wurde das Substrat aus dem Quarzrohr entnommen. Es hatte sich eine gut haftende gleichmäßige Kupferschicht auf dem Substrat gebildet.

### 2.2.4. Anwendung von Polyimid als Substrat

Die Versuchsdurchführung erfolgte wie unter 2.2.3. beschrieben. Die Temperatur in Heizzone 2 wurde diesmal jedoch auf 400 °C eingeregelt. Nach der Entnahme der Probe aus dem Quarzrohr konnte festgestellt werden, daß wiederum eine sehr gut haftende Kupferschicht auf dem Polyimid gebildet worden war.

## Patentansprüche

1. Verfahren zur Abscheidung einer Kupfer enthaltenden Schicht auf einem Substrat, dadurch gekennzeichnet, daß man durch Zersetzung einer Verbindung der allgemeinen Formel R-Cu-L (I), worin R für einen organischen Rest R¹ oder R² steht und
R¹Cyclopentadien und R²substituiertes Cyclopentadien der allgemeinen Formel C₅X¹X²X³X⁴X⁵ bedeutet, worin X¹, X², X³, X⁴ und X⁵ gleich oder verschieden sein können und Wasserstoff; lineares oder verzweigtes Alkyl mit 1 bis 5 C-Atomen; durch Halogen oder durch Organylsilyl, insbesondere Trimethyl- oder Triethylsilyl substituiertes lineares oder verzweigtes Alkyl mit 1 bis 5 C-Atomen; Halogen, insbesondere Chlor; Aryl, insbesondere Phenyl, substituiertes Phenyl, insbesondere Tolyl; Organylsilyl, insbesondere Trimethyl- oder Triethylsilyl, -COOR³, worin R³ für Niedrigalkyl mit 1 bis 3 C-Atomen steht, bedeuten und
L für (C1-C6-Alkyl)isonitril oder Arylisonitril, insbesondere Phenylisonitril oder Tolylisonitril, steht, eine Kupfer enthaltende Schicht auf dem Substrat aufbringt.

2. Verfahren nach Anspruch 1, dadurch gekennzeichnet, daß R für R¹ steht.

3. Verfahren nach Anspruch 1, dadurch gekennzeichnet, daß R für R² steht, wobei X¹, X², X³, X⁴ und X⁵ gleich oder verschieden sein können und Wasserstoff; Methyl, Ethyl, Isopropyl, Trifluormethyl, Phenyl, Chlor oder -COO(Methyl) bedeuten.

4. Verfahren nach Anspruch 1, dadurch gekennzeichnet, daß R Cyclopentadien; Methylcyclopentadien, Ethylcyclopentadien, Isopropylcyclopentadien; Pentamethylcyclopentadien; Trifluormethylcyclopentadien; Tetraphenylcyclopentadien; Methoxycarbonylcyclopentadien; Pentakis(Methoxycarbonyl)cyclopentadien bedeutet.

5. Verfahren nach einem der vorhergehenden Ansprüche, dadurch gekennzeichnet, daß L für Alkylisonitril steht, wobei Alkyl verzweigtes Alkyl mit 3 bis 5 C-Atomen, insbesondere t-Butyl bedeutet.

6. Verfahren nach einem der vorhergehenden Ansprüche, dadurch gekennzeichnet, daß man die Verbindung der allgemeinen Formel (I) in der Gas- bzw. Dampfphase zersetzt.

7. Verfahren nach einem der vorhergehenden Ansprüche, dadurch gekennzeichnet, daß man die Zersetzung thermisch oder mittels Strahlungsenergie, insbesondere Laserstrahlungsenergie, bewirkt.

8. Verfahren nach einem der vorhergehenden Ansprüche, dadurch gekennzeichnet, daß man die Zersetzung der Verbindung der allgemeinen Formel (I) thermisch durch Aufheizen des Substrats auf Temperaturen oberhalb von 80 °C bewirkt.

9. Verfahren nach einem der vorhergehenden Ansprüche, dadurch gekennzeichnet, daß man die Verbindung der allgemeinen Formel (I) bei vermindertem Druck, gewünschtenfalls unter Anwendung eines Trägergases, in die Gas- bzw. Dampfphase überführt und bei vermindertem Druck zersetzt.

10. Verfahren nach einem der vorhergehenden Ansprüche, dadurch gekennzeichnet, daß man zur Abscheidung von Kupfer enthaltenden Schichten, welche das Kupfer im wesentlichen in Form von metallischem Kupfer enthalten, die Zersetzung in Anwesenheit einer gegenüber Kupfer und der verwendeten Verbindung der allgemeinen Formel (I) inerten Gasatmosphäre durchführt.

11. Verfahren nach einem der Ansprüche 1 bis 8, dadurch gekennzeichnet, daß man zur Abscheidung von Kupfer enthaltenden Schichten, welche das Kupfer im wesentlichen in Form von Kupferoxid enthalten, die Zersetzung in Gegenwart einer reaktiven, oxidierenden und/oder hydrolysierenden Gasatmosphäre durchführt.

12. Verfahren nach einem der vorhergehenden Ansprüche, dadurch gekennzeichnet, daß man zur Abscheidung von Kupfer und ein oder mehrere weitere Metalle enthaltenden Schichten auf dem Substrat eine Verbindung der allgemeinen Formel (I) und eine oder mehrere Verbindungen anderer Metalle, insbesondere Aluminiumverbindungen, gleichzeitig oder nacheinander zersetzt.

13. Verfahren nach einem der Ansprüche 1 bis 11, dadurch gekennzeichnet, daß man mehrere unterschiedliche Schichten nacheinander abscheidet.

14. Verfahren nach einem der vorhergehenden Ansprüche, dadurch gekennzeichnet, daß man als Substrat anorganische Materialien, bevorzugt Metalle, Halbleiter, Isolatoren, Keramik oder organische Polymere, insbesondere Polyphenylensulfid oder Polyimid verwendet.

## Claims

1. Process for depositing a copper-containing layer on a substrate, characterised in that a copper-containing layer is applied to the substrate by decomposing a compound of the general formula R-Cu-L (I), wherein R stands for an organic radical R¹ or R² and
R¹ is cyclopentadiene and R² is substituted cyclopentadiene of the general formula C₅X¹X²X³X⁴X⁵, wherein X¹, X², X³, X⁴ and X⁵ may be identical or different and stand for hydrogen; linear or branched alkyl with 1 to 5 C atoms; linear or branched alkyl with 1 to 5 C atoms substituted by halogen or by organylsilyl, in particular trimethylsilyl or triethylsilyl; halogen, in particular chlorine; aryl, in particular phenyl, substituted phenyl, in particular tolyl; organylsilyl, in particular trimethylsilyl or triethylsilyl, -COOR³, wherein R³ stands for lower alkyl with 1 to 3 C atoms, and
L stands for (C1-C6-alkyl)isonitrile or aryl isonitrile, in particular phenyl isonitrile or tolyl isonitrile.

2. Process according to Claim 1, characterized in that R stands for R¹.

3. Process according to Claim 1, characterized in that R stands for R², whereby X¹, X², X³, X⁴ and X⁵ may be identical or different and stand for hydrogen; methyl, ethyl, isopropyl, trifluoromethyl, phenyl, chlorine or -COO(methyl).

4. Process according to Claim 1, characterized in that R stands for cyclopentadiene; methyl cyclopentadiene, ethyl cyclopentadiene, isopropyl cyclopentadiene; pentamethyl cyclopentadiene; trifluoromethyl cyclopentadiene; tetraphenyl cyclopentadiene; methoxycarbonyl cyclopentadiene; pentakis-(methoxycarbonyl)cyclopentadiene.

5. Process according to one of the preceding Claims, characterized in that L stands for alkyl isonitrile, whereby alkyl stands for branched alkyl with 3 to 5 C atoms, in particular t-butyl.

6. Process according to one of the preceding Claims, characterized in that the compound of the general formula (I) is decomposed in the gas or vapour phase.

7. Process according to one of the preceding Claims, characterized in that the decomposition is brought about thermally or by means of radiation energy, in particular laser radiation energy.

8. Process according to one of the preceding Claims, characterized in that the decomposition of the compound of the general formula (I) is brought about thermally by heating the substrate to temperatures above 80°C.

9. Process according to one of the preceding Claims, characterized in that the compound of the general Formula (I) is converted into the gas or vapour phase at reduced pressure, if desired using a carrier gas, and is decomposed at reduced pressure.

10. Process according to one of the preceding Claims, characterised in that for depositing copper-containing layers which contain the copper substantially in the form of metallic copper, the decomposition is carried out in the presence of a gas atmosphere which is inert to copper and to the compound of the general formula (I) used.

11. Process according to one of Claims 1 to 8, characterised in that for depositing copper-containing layers which contain the copper substantially in the form of copper oxide, the decomposition is carried out in the presence of a reactive, oxidising and/or hydrolysing gas atmosphere.

12. Process according to one of the preceding Claims, characterised in that for depositing layers containing copper and one or more other metals on the substrate, a compound of the general formula (I) and one or more compounds of other metals, in particular aluminium compounds, are decomposed at the same time or successively.

13. Process according to one of Claims 1 to 11, characterised in that a plurality of different layers are deposited successively.

14. Process according to one of the preceding Claims, characterised in that inorganic materials, preferably metals, semiconductors, insulators, ceramics or organic polymers, in particular polyphenylene sulphide or polyimide, are used as the substrate.

## Revendications

1. Procédé pour déposer une couche contenant du cuivre sur un substrat, procédé caractérisé en ce qu'on applique sur le substrat une couche contenant du cuivre que l'on obtient par décomposition d'un composé de formule générale R-Cu-L (I), dans laquelle R représente un reste organique R¹ ou R², et
R¹ représente un groupe cyclopentadiène et R² un groupe cyclopentadiène substitué, de formule générale C₅X¹X²X³X⁴X⁵, formule dans laquelle X¹, X², X³, X⁴ et X⁵ peuvent être identiques ou différents et chacun représente un atome d'hydrogène; un groupe alkyle linéaire ou ramifié ayant 1 à 5 atomes de carbone; un groupe alkyle linéaire ou ramifié ayant 1 à 5 atomes de carbone, substitué par de l'halogène ou par un groupe organylsilyle, notamment par un groupe triméthylsilyle ou triéthylsilyle; un atome d'halogène, notamment le chlore; un groupe aryle notamment phényle, phényle substitué, en particulier tolyle, un groupe organylsilyle, notamment triméthylsilyle ou triéthylsilyle, un groupe -COOR³, formule dans laquelle R³ représente un groupe alkyle inférieur ayant 1 à 3 atomes de carbone, et
L représente un groupe (alkyl en C₁ à C₆)-isonitrile ou arylisonitrile, en particulier phénylisonitrile ou tolylisonitrile.

2. Procédé selon la revendication 1, caractérisé en ce que R représente R^{1.}

3. Procédé selon la revendication 1, caractérisé en ce que R représente R² et les symboles X¹, X², X³, X⁴ et X⁵ peuvent être identiques ou différents et ils représentent chacun un atome d'hydrogène; un groupe méthyle, éthyle, isopropyle, trifluorométhyle, phényle, chloro ou -COO (méthyle).

4. Procédé selon la revendication 1, caractérisé en ce que R représente un groupe cyclopentadiène; méthylcyclopentadiène; éthylcyclopentadiène, isopropylcyclopentadiène, pentaméthylcyclopentadiène; trifluorométhylcyclopentadiène; tétraphénylcyclopentadiène; méthoxycarbonylcyclopentadiène, pentakis (méthoxycarbonyl) cyclopentadiène.

5. Procédé selon l'une des revendications précédentes, caractérisé en ce que L représente un groupe alkylisonitrile, dans lequel le groupe alkyle est un groupe alkyle ramifié ayant 3 à 5 atomes de carbone, notamment le groupe t-butyle.

6. Procédé selon l'une des revendications précédentes, caractérisé en ce qu'on soumet le composé de formule générale (I) à une décomposition en phase gazeuse ou de vapeur.

7. Procédé selon l'une des revendications précédentes, caractérisé en ce qu'on effectue la décomposition par voie thermique ou à l'aide d'une énergie de rayonnement, en particulier l'énergie d'un rayonnement laser.

8. Procédé selon l'une des revendications précédentes, caractérisé en ce qu'on effectue la décompositon du composé de formule générale (I) par voie thermique par chauffage du substrat à des températures supérieures à 80°C.

9. Procédé selon l'une des revendications précédentes, caractérisé en ce qu'on décompose le composé de formule générale (I), sous pression réduite et éventuellement en utilisant un véhicule gazeux, en phase gazeuse ou de vapeur et sous pression réduite.

10. Procédé selon l'une des revendications précédentes, caractérisé en ce que, pour provoquer le dépôt des couches contenant du cuivre, qui contiennent le cuivre essentiellement sous forme de cuivre métallique, on effectue la décomposition en présence d'une atmosphère de gaz inerte à l'égard du cuivre et du composé de formule générale (I) que l'on utilise.

11. Procédé selon l'une des revendications 1 à 8, caractérisé en ce que, pour effectuer le dépôt des couches contenant du cuivre, qui contiennent le cuivre essentiellement sous forme d'oxyde de cuivre, on effectue la décomposition en présence d'une atmosphère gazeuse, réactive, oxydante et/ou hydrolysante.

12. Procédé selon l'une des revendications précédentes, caractérisé en ce que, pour provoquer le dépôt de couches contenant du cuivre et un ou plusieurs autres métaux sur le substrat, on décompose, simultanément ou successivement, un composé de formule générale (I) et un ou plusieurs composés d'autres métaux, notamment des composés de l'aluminium.

13. Procédé selon l'une des revendications 1 à 11, caractérisé en ce qu'on provoque le dépôt successif de plusieurs couches différentes.

14. Procédé selon l'une des revendications précédentes, caractérisé en ce que l'on utilise comme substrat des matières minérales, de préférence des métaux, des semi-conducteurs, des isolants, de la matière céramique ou bien des polymères organiques, notamment du polysulfure de phénylène ou du polyimide.
